**Europäisches Patentamt**

**European Patent Office**

**Office européen des brevets**

(19)

(11) **EP 1 388 933 A2**

(12) **EUROPEAN PATENT APPLICATION**

(43) Date of publication:
**11.02.2004 Bulletin 2004/07**

(51) Int Cl.⁷: **H03D 3/00**

(21) Application number: **03254872.9**

(22) Date of filing: **05.08.2003**

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK** | (72) Inventor: **Osada, Shigeru**<br>**Tokyo 145 (JP)** |
| | (74) Representative: **Kensett, John Hinton**<br>**Saunders & Dolleymore,**<br>**9 Rickmansworth Road**<br>**Watford, Hertfordshire WD18 0JU (GB)** |
| (30) Priority: **07.08.2002 JP 2002230442** | |
| (71) Applicant: **ALPS ELECTRIC CO., LTD.**<br>**Ota-ku Tokyo 145 (JP)** | |

(54) **Direct conversion circuit capable of eliminating distirsion of base band signals**

(57)     The direct current circuit comprises first to fourth mixers (1-4) to which high frequency signals and a local oscillation signal having an equal frequency to that of the high frequency signal are inputted, and first and second multiplexer circuits (8, 9) which output components of a sum of two signals. A phase of the high frequency signals which are inputted to the first and second mixers and a phase of the high frequency signals which are inputted to the third and fourth mixers are made to differ from each other by π. A phase of the local oscillation signals which are inputted to the first and third mixers and a phase of the local oscillation signals which are inputted to the second and fourth mixers are made to differ from each other by π/2. The base band signals formed of an in-phase component which are respectively outputted from the first mixer and the third mixer are inputted to the first multiplexer circuit, while the base band signals formed of an ortho-component which are respectively outputted from the second mixer and the fourth mixer are inputted to the second multiplexer circuit.

## FIG. 1

EP 1 388 933 A2

**Description**

BACKGROUND OF THE INVENTION

1. Field of the Invention

The present invention relates to a direct conversion circuit which directly outputs base band signals by a mixer in response to high frequency signals modulated by the base band signals.

2. Description of the Related Art

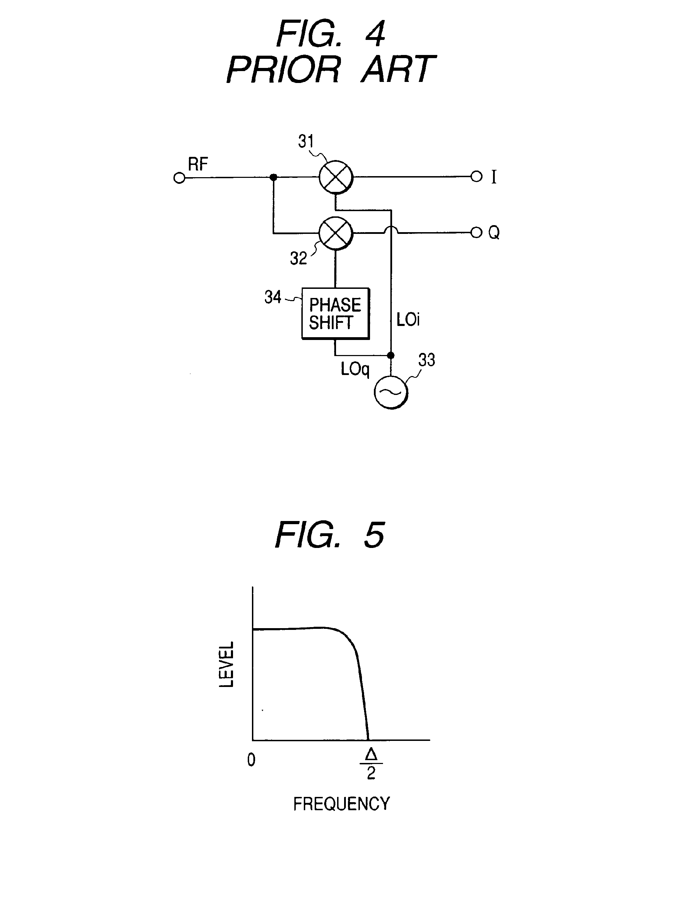

A direct conversion circuit which constitutes the related art is shown in Fig. 4. High frequency signals modulated in response to base band signals (RF signals) are received by a receiver or the like and are inputted to a first mixer 31 and a second mixer 32. Although local oscillation signals having frequency equal to an RF signal (to be more specific, a carrier wave) are supplied to the first and second mixers 31, 32 from an oscillator 33, their phases are different from each other by $\pi/2$ (90°). For example, the in-phase local oscillation signal (LOi) which constitutes the reference signal is inputted to the first mixer 31 and the orthogonal local oscillation signal (LOq) which has the phase thereof delayed by $\pi/2$ by a phase shifter 34 is inputted to the second mixer 32.

In respective mixers 31, 32, the RF signal and the local oscillation signal are mixed. Since the RF signal and the local oscillation signal have the same frequency, as shown in Fig. 5, from the respective mixers 31, 32, a base band signal having a band $\Delta/2$ ($\Delta$ being the original band of the base band signal) in a state that the frequency is in a folded state is outputted at a position where the frequency is 0. Here, the base band signal (I) which constitutes the in-phase component is outputted from the first mixer 31 and the base band signal (Q) which constitutes the ortho-component is outputted from the second mixer 32.

When the RF signal and the local oscillation signal are mixed in the mixer, particularly the level of the local oscillation signal is large and hence, when a mixing semiconductor is excited, the vertical direction of an amplitude becomes asymmetrical so that a so-called DC offset component is generated. Accordingly, there arises a drawback that among the outputted base band signals, the base band signal in the vicinity of the position where the frequency is 0 receives the distortion.

SUMMARY OF THE INVENTION

It is an object of the present invention to eliminate the distortion of base band signals caused by a DC offset component generated by a mixer.

To solve the above-mentioned drawback, the present invention provides a direct conversion circuit which includes first to fourth mixers to which high frequency signals which are modulated in response to base band signals and a local oscillation signal having an equal frequency to that of the high frequency signal are inputted, and first and second multiplexer circuits which output components of a sum of two signals, wherein a phase of the high frequency signals which are inputted to the first and second mixers and a phase of the high frequency signals which are inputted to the third and fourth mixers are made to differ from each other by $\pi$, a phase of the local oscillation signals which are inputted to the first and third mixers and a phase of the local oscillation signals which are inputted to the second and fourth mixers are made to differ from each other by $\pi/2$, the base band signals formed of an in-phase component which are respectively outputted from the first mixer and the third mixer are inputted to the first multiplexer circuit, the base band signals formed of an ortho-component which are respectively outputted from the second mixer and the fourth mixer are inputted to the second multiplexer circuit, and one of the base band signals formed of the in-phase component which is inputted to the first multiplexer circuit and one of the base band signals formed of the ortho-component which is inputted to the second multiplexer circuit have respective phases thereof inverted from each other.

Preferably, the first and second multiplexer circuits respectively have a pair of transistors in which respective emitters are connected to each other and respective collectors are connected to a common load resistance, and the two base band signals formed of the in-phase component and the two base band signals formed of the ortho-component are inputted to a base of the one transistor and a base of the other transistor.

Preferably, the first to fourth mixers and the first and second multiplexer circuits are respectively constituted of a balanced circuit.

An embodiment of the present invention will now be described, by way of example, with reference to the accompanying diagrammatic drawings, in which:

Fig. 1 is a circuit diagram showing the constitution of a direct conversion circuit of the present invention;
Fig. 2 is a circuit diagram showing the constitution of a multiplexer circuit used in the direct conversion circuit of the present invention;
Fig. 3 is a circuit diagram when the multiplexer circuit of the direct conversion circuit of the present invention is constituted of a balanced circuit;
Fig. 4 is a circuit diagram showing the constitution of a conventional direct conversion circuit; and
Fig. 5 a frequency spectrum of a base band signal outputted from the direct conversion circuit.

DESCRIPTION OF THE PREFERRED EMBODIMENTS

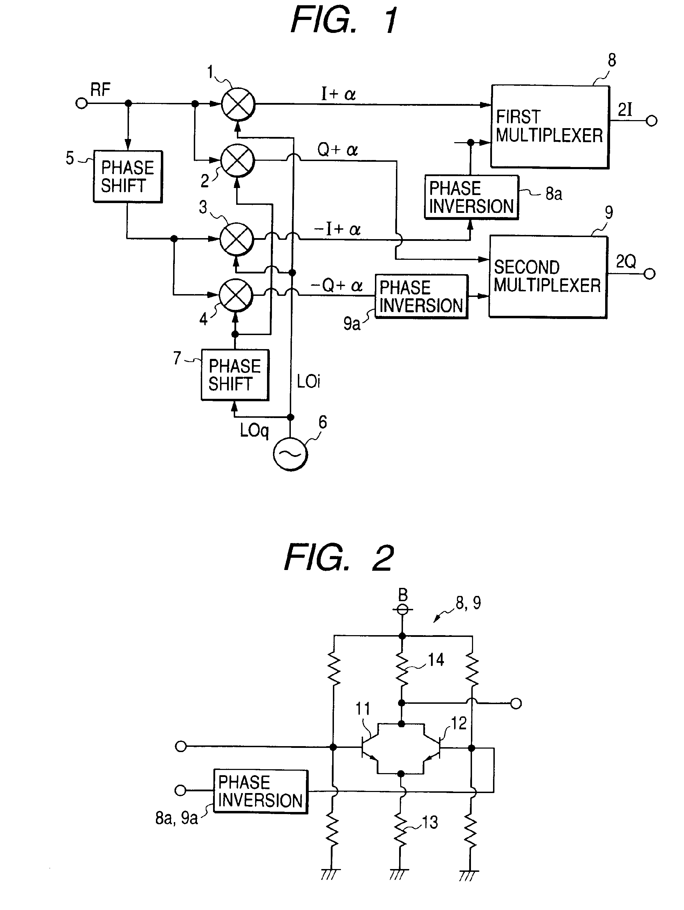

A direct conversion circuit according to the present invention is explained in conjunction with Fig. 1. High frequency signals modulated in response to base band signals (abbreviated as RF signals hereinafter) are received by a receiver or the like and are inputted to first to fourth mixers 1 to 4 having an equal constitution. Here, although RF signals having the same phase are inputted to the first mixer 1 and the second mixer 2, RF signals having a phase thereof delayed (phase inversion) by $\pi$ by a phase shifter 5, for example, are inputted to the third mixer 3 and the fourth mixer 4.

Local oscillation signals are supplied to the first to fourth mixers 1 to 4 from an oscillator 6. The frequency of the local oscillation signals is the same as that of the RF signals (to be more specific, carrier waves). The in-phase local oscillation signals (LOi) which become the reference signals are supplied to the first mixer 1 and the third mixer 3 and the orthogonal local oscillation signals which have a phase thereof delayed by $\pi/2$ (90°) by a phase shifter 7 (LOq) are supplied to the second mixer 2 and the fourth mixer 4.

In the above-mentioned constitution, in the first mixer 1, the RF signals and the in-phase local oscillation signals (LOi) are mixed and base band signals I are outputted. Simultaneously, DC offset components $\alpha$ are also outputted. These DC offset components $\alpha$ are generated when a semiconductor device for mixing in the mixer is excited particularly by the local oscillation signals having a large amplitude. On the other hand, in the second mixer 2, the RF signals and the orthogonal local oscillation signals (LOq) are mixed and the base band signals Q are outputted. Assuming that the second mixer 2 has the same constitution as the first mixer 1, the DC offset components $\alpha$ having the same level are also outputted simultaneously.

Further, in the third mixer 3, the phase-inverted RF signals and the in-phase local oscillation signals (LOi) are mixed and the base band signals -I (minus symbol (-) meaning that the phase is inverted) are outputted. Simultaneously, the DC offset components $\alpha$ are also outputted.

Further, in the fourth mixer 4, the phase-inverted RF signals and the orthogonal local oscillation signals (LOq) are mixed and the base band signals -Q are outputted. Simultaneously, the DC offset components $\alpha$ are also outputted.

The baseband signals and the DC offset components (I+$\alpha$) outputted from the first mixer 1 and the base band signals and the DC offset components (-I+$\alpha$) outputted from the third mixer 3 are inputted to a first multiplexer circuit 8. Further, the base band signals and the DC offset components (Q+$\alpha$) outputted from the second mixer 2 and the base band signals and the DC offset components (-Q+$\alpha$) outputted from the fourth mixer 4 are inputted to a second multiplexer circuit 9.

The first multiplexer circuit 8 and the second multiplexer circuit 9 have the same constitution and respectively output components of a sum of two inputted signals . Accordingly, by providing phase-inversion circuits 8a, 9a in preceding stages of respective one input terminals of the first multiplexer circuit 8 and the second multiplexer circuit 9, 2I is outputted from the first multiplexer circuit 8 based on the following formula:

$$(I + \alpha) - (-I + \alpha) = 2I$$

and 2Q is outputted from the second multiplexer circuit 9 based on the following formula:

$$(Q + \alpha) - (-Q + \alpha) = 2Q.$$

That is, by making the base band signals containing the DC offset components $\alpha$ pass through the multiplexer circuits 8, 9, the DC offset components $\alpha$ can be eliminated.

Fig. 2 shows one example of the constitution of the multiplexer circuits 8, 9. In a pair of transistors 11, 12, respective emitters are connected to each other and are connected to a ground through a bias resistance 13 and respective collectors are connected to a power source B through a common load resistance 14. The base band signals (I+$\alpha$) containing the DC offset components outputted from the first mixer 1 (or the base band signals (Q+$\alpha$) containing the DC offset components outputted from the second mixer 2) are inputted to a base of one transistor 11 and the base band signals (-I+$\alpha$) containing the DC offset components outputted from the third mixer 3 (or the base band signals (-Q+$\alpha$) containing the DC offset components outputted from the fourth mixer 4) are inputted through the phase-inversion circuits 8a, 9a to a base of another transistor 12. The two transistors 11, 12 are operated differentially by the phase-inversion circuits 8a, 9a and hence, the DC offset components $\alpha$ are cancelled and only the pure base band signals I or Q are outputted from the collectors.

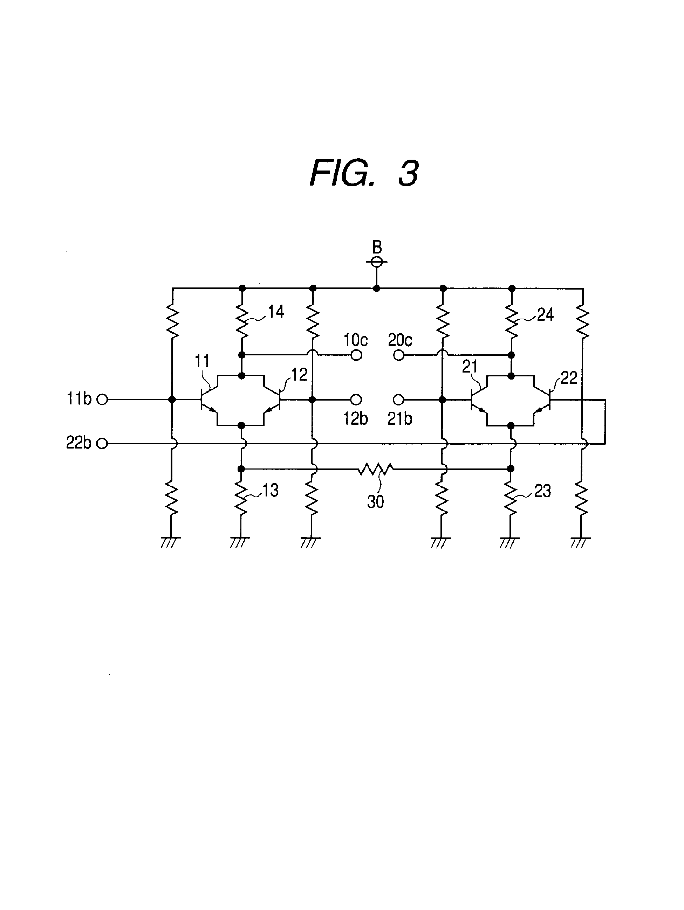

In the foregoing explanation, with respect to the first to fourth mixers 1 to 4 and the first and second multiplexer. circuits 8, 9, a balanced circuit and an unbalanced circuit are not especially differentiated. However, when the direct conversion circuit is constituted of a balanced circuit, the phase-shifter 5 becomes unnecessary and, at the same time, the direct conversion circuit becomes advantageous with respect to distortions. Further, the phase-inversion circuits 8a, 9a also become unnecessary. In that case, as the first and second multiplexers 8, 9, as shown in Fig. 3, the second pair of transistors 21, 22 are used besides the first pair of transistors 11, 12 shown in Fig. 2. Emitters of these transistors 21, 22 are connected to a ground through bias resistance 23 and collectors of these transistors 21, 22 are connected to the power source B through a common load resistance 24. The emitters of the first pair of the transistors 11 and 12 and the emitters of the second pair of the transistors 21 and 22 are connected through a resistance 30. Accordingly, the first pair of transistors 11 and 12 and the second pair of transistors 21 and 22 are also differentially operated. Consequently, when the base band signals contain the in-phase distortion components other than the DC offset components, these components are cancelled and hence, the direct conversion circuit becomes more advantageous with respect to distortions.

Then, between a base terminal 11b of one transistor 11 out of the first pair of transistors 11, 12 and a base terminal 22b of one transistor 22 out of the second pair of transistors 21, 22, the base band signals (I+$\alpha$) containing the DC offset components outputted from the first mixer 1 (or the base band signals (Q+$\alpha$) containing the DC offset components outputted from the second mixer 2) are inputted in a balanced manner. Further, between a base terminal 12b of another transistor 12 out of the first pair of transistors 11, 12 and a base terminal 21b of another transistor 21 out of the second pair of transistors 21, 22, the base band signals (-I+$\alpha$) containing the DC offset components outputted from the third mixer 3 (or the base band signals (-Q+$\alpha$) containing the DC offset components outputted from the fourth mixer 4) are inputted in a balanced manner.

Accordingly, between a collector terminal 10c of the first pair of transistors 11 and 12 and a collector terminal 20c of the second pair of transistors 21 and 22, the base band signals I or Q from which the DC offset components are eliminated are inputted in a balanced manner.

As has been explained heretofore, according to the present invention, the phase of the high frequency signals which are inputted to the first and second mixers and the phase of the high frequency signals which are inputted to the third and fourth mixers are made to differ from each other by $\pi$. The phase of the local oscillation signals which are inputted to the first and third mixers and the phase of the local oscillation signals which are inputted to the second and fourth mixers are made to differ from each other by $\pi/2$. The base band signals formed of the in-phase component which are respectively outputted from the first mixer and the third mixer are inputted to the first multiplexer circuit. The base band signals formed of the ortho-component which are respectively outputted from the second mixer and the fourth mixer are inputted to the second multiplexer circuit. Accordingly, only the in-phase base band signals from which the DC offset components generated in the first and third mixers are eliminated can be outputted from the first multiplexer circuit and the only the ortho-phase base band signals from which the DC offset components generated in the second and fourth mixers are eliminated can be outputted from the second multiplexer circuit.

Further, each of the first and second multiplexer circuits has a pair of transistors which have respective emitters thereof connected to each other and respective collectors thereof connected to the common load resistance and the phase inversion circuit which is provided in the preceding stage of another transistor. Further, two base band signals of in-phase components or two base band signals of ortho-components are inputted to the base of another transistor and the phase inversion circuit. Accordingly, only the base band signals from which the DC offset components are eliminated can be easily outputted to the collectors.

Further, the first to fourth mixers and the first and second multiplexer circuits are respectively constituted of a balanced circuit and hence, the base band signals can be inputted in a phase-inversed manner to the multiplexer circuits without requiring the phase inversion circuit. Further, the distortion components other than the DC offset components can be eliminated.

**Claims**

1. A direct conversion circuit comprising first to fourth mixers to which high frequency signals which are modulated in response to base band signals and a local oscillation signal having an equal frequency to that of the high frequency signal are inputted, and first and second multiplexer circuits which output components of a sum of two signals, wherein

    a phase of the high frequency signals which are inputted to the first and second mixers and a phase of the high frequency signals which are inputted to the third and fourth mixers are made to differ from each other by $\pi$;

    wherein a phase of the local oscillation signals which are inputted to the first and third mixers and a phase of the local oscillation signals which are inputted to the second and fourth mixers are made to differ from each other by $\pi/2$;

    wherein the base band signals formed of an in-phase component which are respectively outputted from the first mixer and the third mixer are inputted to the first multiplexer circuit;

    wherein the base band signals formed of an ortho-component which are respectively outputted from the second mixer and the fourth mixer are inputted to the second multiplexer circuit; and

    wherein one of the base band signals formed of the in-phase component which is inputted to the first multiplexer circuit and one of the base band signals formed of the ortho-component which is inputted to the second multiplexer circuit have respective phases thereof inverted from each other.

2. A direct conversion circuit according to claim 1, wherein the first and second multiplexer circuits respectively include a pair of transistors in which respective emitters are connected to each other and respective collectors are connected to a common load resistance, and wherein the two base band signals formed of the in-phase component and the two base band signals formed of the ortho-component are inputted to a base of one transistor and a base of another transistor.

3. A direct conversion circuit according to claim 1, wherein the first to fourth mixers and the first and second multiplexer circuits are respectively constituted of a balanced circuit.

# FIG. 1

# FIG. 2

# FIG. 3

# FIG. 4
# PRIOR ART

# FIG. 5